# EUROPÄISCHE PATENTSCHRIFT

(11) **EP 0 974 848 B1**
(45) Veröffentlichungstag und Bekanntmachung des Hinweises auf die Patenterteilung: **28.12.2005**
(21) Anmeldenummer: 99113094.9
(22) Anmeldetag: 06.07.1999
(51) Int. Cl.: G01R 31/3187, G01R 31/3185

(54) **Integrierte Schaltung mit einer Selbsttesteinrichtung**
Integrated circuit with self-testing device
Circuit intégré avec dispositif à auto-test

(30) Priorität: 17.07.1998 DE 19832307
(43) Veröffentlichungstag der Anmeldung: 26.01.2000
(73) Patentinhaber: Infineon Technologies AG, 81669 München (DE)
(72) Erfinder: Schaffroth, Thilo, 85244 Röhrmoos (DE); Schamberger, Florian, 83435 Bad Reichenhall (DE); Schneider, Helmut, 80993 München (DE)
(74) Vertreter: Hoffmann, Jörg Peter

(56) Entgegenhaltungen:
- EP-A- 0 330 841
- EP-A- 0 852 354

## Beschreibung

Die Erfindung betrifft eine integrierte Schaltung mit einer Selbsttesteinrichtung zur Durchführung eines Selbsttests der integrierten Schaltung.

Eine derartige integrierte Schaltung ist beispielsweise in der US-A 5,173,906 beschrieben. Die Selbsttesteinrichtung, ein sogenanntes Built-In-Self-Test-System, ist integraler Bestandteil der integrierten Schaltung. Sie enthält einen Prüfmuster-Generator zur Erzeugung von Testsignalen, die zu testenden Schaltungseinheiten der integrierten Schaltung zugeführt werden. Ergebnissignale über den durchgeführten Test werden On-Chip generiert und werden nach Durchführung des Tests nach außerhalb des Chips ausgelesen. Die Testsignale werden von der Selbsttesteinrichtung zu den zu testenden Schaltungseinheiten über auf dem Chip befindliche Datenleitungen übertragen.

In der EP 0 852 354 B1 ist eine integrierte Schaltung mit einer Selbsttesteinrichtung beschrieben, bei der innerhalb dieser integrierten Schaltung eine Selbsttesteinrichtung (BIST) einer bei der zu testenden Schaltungseinheit der integrierten Schaltung ein Testsignal über eine auch zur externen Kontaktierung der integrierten Schaltung dienende Kontaktierungsstelle zuführt.

Der Erfindung liegt die Aufgabe zugrunde, eine integrierte Schaltung der eingangs genannten Art anzugeben, die eine verbesserte Testbarkeit mittels ihrer Selbsttesteinrichtung bietet.

Diese Aufgabe wird mit einer integrierten Schaltung gemäß Anspruch 1 gelöst. Vorteilhafte Weiterbildungen der Erfindung sind Gegenstand der abhängigen Ansprüche 2 bis 4. Bei der erfindungsgemäßen integrierten Schaltung ist also ein Ausgang der Selbsttesteinrichtung mit einer Kontaktierungsstelle der Schaltung verbunden, die einer externen Kontaktierung dient und die mit dem Eingang einer zu testenden Schaltungseinheit der integrierten Schaltung verbunden ist. Dabei führt die Selbsttesteinrichtung der zu testenden Schaltungseinheit ein Testsignal über die Kontaktierungsstelle zu. Die Testsignale werden so über die Kontaktierungsstelle geführt, die einer externen Kontaktierung mittels beispielweise Prüfspitzen eines Testgerätes oder mittels eines Bonddrahtes dienen kann. Dieses Vorgehen hat gegenüber einer direkten Zuführung des Testsignals zum Eingang der zu testenden Schaltungseinheit den Vorteil, dass auf diese Weise auch die Verbindung zwischen der Kontaktierungsstelle und dem Eingang der zu testenden Schaltungseinheit geprüft wird. Somit wird der zu testenden Schaltungseinheit das Testsignal in einer Weise zugeführt, wie dies außerhalb des Testbetriebs mit extern über die Kontaktierungsstelle zugeführten Signalen der Fall ist. Damit ist die Überprüfung der Verbindung zwischen Kontaktierungsstelle und zu testender Schaltungseinheit möglich, ohne dass aufwändige Änderungen der integrierten Schaltung oder ihrer Selbsttesteinrichtung notwendig sind. Es ist lediglich der Ausgang der Selbsttesteinrichtung nicht direkt mit dem Eingang der zu testenden Schaltungseinheit, sondern mit der Kontaktierungsstelle zu verbinden. Insbesondere kann der Aufbau der Selbsttesteinrichtung und die Art der von ihr generierten Prüfmuster bzw. Testsignale sowie die Art der Generierung eines Ergebnissignals für die durchgeführte Prüfung und das Ausgeben des Ergebnisses nach außerhalb der integrierten Schaltung genauso gestaltet sein wie bei herkömmlichen integrierten Schaltungen mit Selbsttesteinrichtungen.

Die Kontaktierungsstelle ist über einen Eingangstreiber mit dem Eingang der zu testenden Schaltungseinheit verbunden, der in einer Normalbetriebsart der integrierten Schaltung der Zuführung von externen Signalen zur zu testenden Schaltungseinheit dient, wobei die Selbsttesteinrichtung in einer Testbetriebsart das Testsignal zur Kontaktierungsstelle und von dort über den Eingangstreiber zum Eingang der zu testenden Schaltungseinheit überträgt.

Dies hat den Vorteil, dass zur Zuführung des Testsignals zur Schaltungseinheit auf bereits in der Normalbetriebsart benötigte Komponenten - nämlich den Eingangstreiber sowie die damit verbundenen Datenleitungen - zurückgegriffen wird. Außerdem wird dieser Eingangstreiber auf diese Weise in die Überprüfung durch die Selbsttesteinrichtung einbezogen.

Der Ausgang der Schaltungseinheit ist mit der Kontaktierungsstelle über einen Ausgangstreiber verbunden, welcher in der Normalbetriebsart zur Ausgabe von Signalen der Schaltungseinheit nach außerhalb der integrierten Schaltung dient. Außerdem ist der Ausgang der Selbsttesteinrichtung ebenfalls über den Ausgangstreiber mit der Kontaktierungsstelle verbunden, wobei die Selbsttesteinrichtung in der Testbetriebsart das Testsignal über den Ausgangstreiber zur Kontaktierungsstelle überträgt.

Diese Beschaltung des Ausgangstreibers bietet den Vorteil, dass nur ein einziger Ausgangstreiber notwendig ist, um einerseits in der Testbetriebsart das Testsignal von der Selbsttesteinrichtung zur Kontaktierungsstelle zu übertragen und andererseits in der Normalbetriebsart der Ausgabe von Signalen der weiteren Schaltungseinheit über die Kontaktierungsstelle nach außerhalb der integrierten Schaltung. Außerdem wird der Ausgangstreiber in die Überprüfung durch die Selbsttesteinrichtung einbezogen.

Außerdem wird das Testsignal von der Selbsttesteinrichtung zur Kontaktierungsstelle bzw. von der Kontaktierungsstelle zum Eingang der zu testenden Schaltungseinheit über bereits in der Normalbetriebsart benötigte und daher ohnehin vorhandene Treiber übertragen, so dass keine zusätzlichen elektrischen Verbindungen und Treiber vorgesehen werden müssen. Weiterhin wird durch die Zuführung des Testsignals über die beiden Treiber sowohl der Eingangstreiber der zu testenden Schaltungseinheit als auch ihr Ausgangstreiber durch die Selbsttesteinrichtung getestet, so dass mit nur geringem Aufwand neben der zu testenden Schaltungseinheit auch die genannten Treiber und die damit verbundenen Leitungen geprüft werden.

Nach einer Weiterbildung der Erfindung ist der Ausgang der Selbsttesteinrichtung derart mit dem Ausgang der Schaltungseinheit verbunden, dass die Selbsttesteinrichtung in der Testbetriebsart das Testsignal zunächst zum Ausgang der Schaltungseinheit und von dort über den Ausgangstreiber zu Kontaktierungsstelle überträgt.

Diese hat den Vorteil, dass der gesamte Ausgangsdatenpfad der Schaltungseinheit von deren Ausgang bis zur Kontaktierungsstelle in die Prüfung durch die Selbsttesteinrichtung einbezogen wird.

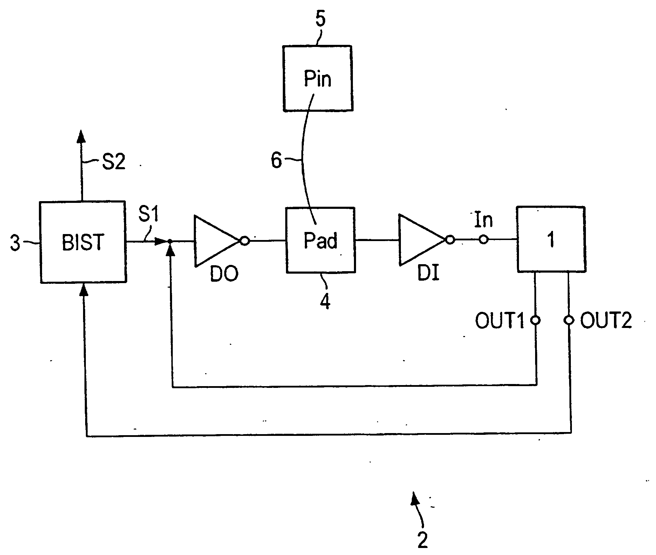

Die Erfindung wird im Folgenden anhand der einzigen Figur beschrieben, die ein Ausführungsbeispiel darstellt.

Die Figur zeigt ein Ausführungsbeispiel der erfindungsgemäßen integrierten Schaltung 2, die beispielsweise eine logische Schaltung oder eine Speicherschaltung sein kann. Sie enthält eine zu testende Schaltungseinheit 1, die beispielsweise zur Ausführung logischer Funktionen dienen kann. Die Schaltungseinheit kann auch ein Speicherzellenfeld der integrierten Schaltung sein. Ein externer Anschluss 5 (Pin) des Chips 2 ist über einen Bonddraht 6 mit einer Kontaktierungsstelle 4 (Pad) verbunden, die wiederum über einen Eingangstreiber DI mit einem Eingang In der Schaltungseinheit 1 verbunden ist. Ein erster Ausgang OUT1 der Schaltungseinheit 1 ist über einen Ausgangstreiber DO mit der Kontaktierungsstelle 4 verbunden. Über die soeben beschriebenen elektrischen Verbindungen werden der Schaltungseinheit 1 in einer Normalbetriebsart der integrierten Schaltung 2 Signale von außerhalb der integrierten Schaltung über den externen Anschluss 5 sowie den Eingangstreiber DI zugeführt, und die Schaltungseinheit 1 gibt zu anderen Zeitpunkten Signale über den Ausgangstreiber DO und den externen Anschluss 5 nach außerhalb des Chips 2 aus.

Zur Durchführung eines Selbsttests in einer Testbetriebsart des Chips 2 weist dieser außerdem eine Selbsttesteinrichtung 3 (BIST = Built-In Self-Test) auf. Die Selbsttesteinrichtung 3 generiert ein Testsignal Sl, welches sie in der Testbetriebsart über den Ausgangstreiber DO der Kontaktierungsstelle 4 und von dieser über den Eingangstreiber DI dem Eingang der Schaltungseinheit 1 zuführt. Ein zweiter Ausgang OUT2 der Schaltungseinheit 1 ist mit dem Eingang der Selbsttesteinrichtung 3 verbunden, so dass in der Testbetriebsart durch die Selbsttesteinrichtung 3 festgestellt werden kann, welche Signale die Schaltungseinheit 1 aufgrund des ihr zugeführten Testsignals S1 generiert. Die Selbsttesteinrichtung 3 führt einen Soll-Ist-Vergleich zwischen den von der Schaltungseinheit 1 übermittelten Signalen und in der Selbsttesteinrichtung 3 gespeicherten Werten durch und übermittelt ein entsprechendes Ergebnissignal S2 nach außerhalb der integrierten Schaltung.

Während in der Normalbetriebsart gleichzeitig nur entweder der Eingangstreiber DI zur Zuführung externer Signale zur Schaltungseinheit 1 oder der Ausgangstreiber DO zur Ausgabe von von der Schaltungseinheit 1 an ihrem ersten Ausgang OUT1 erzeugten Signalen nach außerhalb des Chips 2 aktiviert ist, sind in der Testbetriebsart beide Treiber DO, DI gleichzeitig aktiv, um das Testsignal S1 von der Selbsttesteinrichtung 3 zur Schaltungseinheit 1 zu übertragen.

Der Ausgang der Selbsttesteinrichtung 3 ist nicht direkt mit dem Eingang der Schaltungseinheit 1, sondern indirekt über die Kontaktierungsstelle 4 verbunden. Dies bietet den Vorteil, dass durch die Selbsttesteinrichtung 3 zusätzlich auch der in der Normalbetriebsart genutzte Datenpfad zwischen der Kontaktierungsstelle 4 und dem Eingang IN der Schaltungseinheit 1 in die Prüfung einbezogen wird. Da beim in der Figur dargestellten Ausführungsbeispiel das Testsignal S1 der Kontaktierungsstelle 4 über den von der Schaltungseinheit 1 in der Normalbetriebsart zur Ausgabe von Daten genutzten Ausgangstreiber DO zugeführt wird, wird auch dieser in der Testbetriebsart in die Prüfung durch die Selbsttesteinrichtung 3 einbezogen.

Der Ausgang der Selbsttesteinrichtung 3 kann auch direkt mit dem ersten Ausgang OUT1 der Schaltungseinheit 1 verbunden sein, so dass das Testsignal Sl den gesamten Ausgangsdatenpfad der Schaltungseinheit vom ersten Ausgang OUT1 zur Kontaktierungsstelle durchläuft und auf diese Weise der gesamte Ausgangsdatenpfad in die Überprüfung durch die Selbsttesteinrichtung einbezogen wird.

Die Selbsttesteinrichtung kann entweder als verdrahtete Logik realisiert sein oder einen Controller oder Prozessor enthalten, der von extern ladbare Testprogramme ausführt.

## Patentansprüche

1. Integrierte Schaltung mit einer Selbsttesteinrichtung (3) zur Durchführung eines Selbsttests der integrierten Schaltung (2) und mit einer zu testenden Schaltungseinheit (1), wobei:
- ein Ausgang der Selbsttesteinrichtung (3) über eine interne Kontaktierungsstelle (4) der integrierten Schaltung mit einem Eingang (In) der zu testenden Schaltungseinheit (1) verbunden und diese interne Kontaktierungsstelle (4) an einen externen Anschluß (5) angeschlossen ist,
- die Selbsttesteinrichtung (3) der Schaltungseinheit (1) ein Testsignal (S1) über die Kontaktierungsstelle (4) zuführt, und
- die Kontaktierungsstelle (4) an den Eingang eines Eingangstreibers (DI) angeschlossen ist, der mit seinem Ausgang mit dem in einer Normalbetriebsart der integrierten Schaltung zur Zuführung von externen Signalen dienenden Eingang (In) der Schaltungseinheit (1) verbunden ist,
**dadurch gekennzeichnet, dass**
- ein Ausgang (OUT1) der Schaltungseinheit (1), der in der Normalbetriebsart zur Ausgabe von Signalen der Schaltungseinheit (1) nach außerhalb der integrierten Schaltung dient, über einen Ausgangstreiber (DO) mit der Kontaktierungsstelle (4) verbunden ist, und
- der Ausgang der Selbsttesteinrichtung (3) ebenfalls über den Ausgangstreiber (DO) mit der Kontaktierungsstelle (4) verbunden ist.

2. Integrierte Schaltung nach Anspruch 1,
**dadurch gekennzeichnet, dass**
die Selbsttesteinrichtung (3) in einer Testbetriebsart der integrierten Schaltung das Testsignal (S1) zur Kontaktierungsstelle (4) und von dort über den Eingangstreiber (DI) zur Schaltungseinheit (1) überträgt.

3. Integrierte Schaltung nach Anspruch 1 oder 2,
**dadurch gekennzeichnet, dass**
die Selbsttesteinrichtung (3) in der Testbetriebsart das Testsignal (S1) über den Ausgangstreiber (DO) zur Kontaktierungsstelle (4) überträgt.

4. Integrierte Schaltung nach Anspruch 3,
**dadurch gekennzeichnet, dass**
der Ausgang der Selbsttesteinrichtung (3) derart mit dem Ausgang (OUT1) der Schaltungseinheit (1) verbunden ist, dass die Selbsttesteinrichtung (3) das Testsignal (S1) in der Testbetriebsart zunächst zum Ausgang der Schaltungseinheit (1) und von dort über den Ausgangstreiber (DO) zur Kontaktierungsstelle (4) überträgt.

## Claims

1. Integrated circuit having a self-test device (3) for carrying out a self-test of the integrated circuit (2) and having a circuit unit (1) to be tested, in which:
- via an internal contact-making point (4) of the integrated circuit to an input (In) of the circuit unit (1) to be tested and this internal contact-making point (4) is connected to an external terminal (5),
- the self-test device (3) feeds a test signal (S1) to the circuit unit (1) via the contact-making point (4), and
- the contact-making point (4) is connected to the input of an input driver (DI), which is connected by its output to the input (In) of the circuit unit (1), which serves for feeding in external signals in a normal operating mode of the integrated circuit,
**characterized in that**
- an output (OUT1) of the circuit unit (1), which, in the normal operating mode, serves for outputting signals of the circuit unit (1) to a point outside the integrated circuit, is connected via an output driver (DO) to the contact-making point (4), and
- the output of the self-test device (3) is likewise connected via the output driver (DO) to the contact-making point (4).

2. Integrated circuit according to Claim 1, **characterized in that** the self-test device (3), in a test operating mode of the integrated circuit, transmits the test signal (S1) to the contact-making point (4) and from there via the input driver (DI) to the circuit unit (1).

3. Integrated circuit according to Claim 1 or 2, **characterized in that** the self-test device (3), in the test operating mode, transmits the test signal (S1) via the output driver (DO) to the contact-making point (4).

4. Integrated circuit according to Claim 3, **characterized in that** the output of the self-test device (3) is connected to the output (OUT1) of the circuit unit (1) in such a way that the self-test device (3) transmits the test signal (S1), in the test operating mode, first of all to the output of the circuit unit (1) and from there via the output driver (DO) to the contact-making point (4).

## Revendications

1. Circuit intégré comprenant un dispositif (3) d'autotest pour effectuer un autotest du circuit (2) intégré et comprenant une unité (1) de circuit à tester, dans lequel :
- une sortie du dispositif (3) d'autotest est reliée par un point (4) interne de contact du circuit intégré à une entrée (In) de l'unité (1) de circuit à tester et ce point (4) interne de contact est raccordé à une borne (5) extérieure ;
- le dispositif (3) d'autotest envoie à l'unité (1) de circuit un signal (S1) de test par l'intermédiaire du point (4) de contact ; et
- le point (4) de contact est raccordé à un circuit (DI) d'attaque d'entrée qui est relié par sa sortie à l'entrée (In), servant dans le type de fonctionnement normal du circuit intégré à l'amenée de signaux extérieurs, de l'unité (1) de circuit,
**caractérisé en ce que**
- une sortie (OUT1) de l'unité (1) de circuit qui sert, dans le type de fonctionnement normal, à l'émission de signaux de l'unité (1) de circuit vers l'extérieur du circuit intégré, est reliée par un circuit (DO) d'attaque de sortie au point (4) de contact ; et
- la sortie du dispositif (3) d'autotest est reliée également au point (4) de contact par l'intermédiaire du circuit (DO) d'attaque de sortie.

2. Circuit intégré suivant la revendication 1, **caractérisé en ce que** le dispositif (3) d'autotest transmet dans un type de fonctionnement de test du circuit intégré le signal (S1) de test au point (4) de contact et de là à l'unité (1) de circuit en passant par le circuit (D1) d'attaque d'entrée ;

3. Circuit intégré suivant la revendication 1 ou 2, **caractérisé en ce que** le dispositif (3) d'autotest transmet dans le type de fonctionnement de test le signal (S1) de test par l'intermédiaire du dispositif (DO) d'attaque de sortie au point (4) de contact.

4. Circuit intégré suivant la revendication 3, **caractérisé en ce que** la sortie du dispositif (3) d'autotest est reliée à la sortie (OUT1) de l'unité (1) de circuit, de sorte que le dispositif (3) d'autotest transmet le signal (S1) de test dans le type de fonctionnement de test d'abord à la sortie de l'unité (1) de circuit et de là au point (4) de contact par l'intermédiaire du circuit (DO) d'attaque de sortie.
